# EUROPEAN PATENT SPECIFICATION

(11) **EP 1 843 389 B1**
(45) Date of publication and mention of the grant of the patent: **13.08.2008**
(21) Application number: 06112217.2
(22) Date of filing: 04.04.2006
(51) Int. Cl.: H01L 21/223, H01L 21/225, H01L 27/142, H01L 31/18, H01L 31/04

(54) **Method of providing doping concentration based on diffusion, surface oxidation and etch-back steps, and method of producing solar cells**
Verfahren zur Dotierung mit Hilfe von Diffusion, Oberflächenoxidation und Rückätzung sowie Verfahren zur Herstellung von Solarzellen
Procédé de dopage au moyen de diffusion, oxydation superficielle et rétrogravure ainsi que procédé de fabrication d'une cellule solaire

(43) Date of publication of application: 10.10.2007
(73) Proprietor: SolarWorld Industries Deutschland GmbH, 81739 München (DE)
(72) Inventor: Toelle, Rainer, 80939 München (DE)
(74) Representative: Rau, Albrecht

(56) References cited:
- US-A- 4 152 824
- US-A- 4 377 901
- US-A- 5 871 591
- US-A1- 2004 259 335
- US-B1- 6 552 414
- RUBY D S ET AL: "Self-aligned selective-emitter plasma-etchback and passivation process for screen-printed silicon solar cells" SOLAR ENERGY MATERIALS AND SOLAR CELLS, ELSEVIER SCIENCE PUBLISHERS, AMSTERDAM, NL, vol. 48, no. 1-4, November 1997 (1997-11), pages 255-260, XP004111856 ISSN: 0927-0248
- PEYMAN SANA ET AL: "FABRICATION AND ANALYSIS OF HIGH-EFFICIENCY POLYCRYSTALLINE SILICON SOLAR CELLS" IEEE TRANSACTIONS ON ELECTRON DEVICES, IEEE SERVICE CENTER, PISACATAWAY, NJ, US, vol. 40, no. 8, 1 August 1993 (1993-08-01), pages 1461-1467, XP000383745 ISSN: 0018-9383

## Description

### Field of the Invention

The present application relates to a method of providing a predetermined doping concentration at a surface of a semiconductor substrate, e.g. in an emitter section of a photovoltaic element.

### Background of the Invention

In the field of semiconductor manufacturing, such as when manufacturing photovoltaic elements like solar cells, it can become necessary to adjust the concentration of a dopant at the surface of a semiconductor substrate, in order to provide desired electrical properties, e.g. in view of contactability etc.

In the field of solar cell manufacturing, the concept of etch back is known. This technique is used for producing high efficiency solar cells that have an efficiency in the range of 22 to 25%. Solar cells of this kind are only produced in laboratory conditions and not in mass industrial manufacturing, as process control is extremely difficult. In the known etch back technique for producing an emitter of a photovoltaic element, an emitter layer is produced by first conducting gas phase emitter diffusion, e.g. using POCl3, and then conducting a thermal oxidation step at high temperature, in order to simultaneously drive in the phosphorus dopant by thermal diffusion and oxidize the surface. It is difficult to control this process is such a way as to achieve a desired doping profile and to generate an oxide of desired thickness, such that the shape of the doping profile and the concentration at the surface after oxide removal is in a desired range. As already mentioned, the etch back technique is not suitable for the mass production of semiconductor elements in industrial manufacturing, due to its complexity. In connection with the production of photovoltaic elements, there is the additional disadvantage that the known technique for producing etch back emitters produces surface doping concentrations that are too low for industrial metallisation processes using screen-printing of metallic pastes, because such a metallisation technique requires sufficiently high dopant surface concentration for the creation of an ohmic contact. In the use of etch back for high efficiency solar cells this is not a problem, as the metallisation and contact processes are done by means of photolithography.
In connection with general semiconductor processing it is known to use oxidizing solutions such as H₂O+O₃, NH₄OH+H₂O₂, or HF+H₂O₂ for cleaning semiconductor surfaces, i.e. removing impurities. For example, document EP 0 731 495 A2 specifically describes using a solution comprising O₃, deionised water and HF as a replacement for the previously known RCA cleaning.

Document US 4 377 901 describes a method of manufacturing solar cells in which a series of doped and undoped layers is deposited alternately on the surfaces of a substrate after which the thus prepared substrate is heated to facilitate the diffusion of the dopants into the substrate. In a final step the deposits are dissolved.

Document US 4 152 824 describes a method of producing a p-n-junction of a solar cell with geometrically defined shallow and deep junction regions : The method comprises the deposition of doped oxide on a substrate, the anti-diffusion of dopants from the doped oxide into the substrate and etch-back of the oxide from the surface of the substrate.

Document XP000383745 discloses an etch-back process of an emitter of a solar cell by immersing the solar cell substrate wite said emitter in a HNO₃: HF: H₂O etch solution and therefore providing the oxidizing agent and oxide removing agent the etch-back process at the same time.

There is a need for a simpler and less complicated method of providing a predetermined doping concentration at a surface of a semiconductor substrate, especially a method applicable to industrial mass manufacturing.

### Summary of the Invention

The present invention provides a method of providing a predetermined doping concentration at a surface of a semiconductor substrate, comprising
applying a dopant material to said surface and performing a diffusion step for providing a predetermined doping profile from said surface into a body of said semiconductor substrate, and
etching back said surface by performing an oxidization of said surface for generating an oxide thereon, and etching off said oxide, wherein said oxidization is a chemical oxidization that is performed by employing a substance or compound that oxidizes the semiconductor substrate at a low temperature between 20°C and 90°C and that leaves said doping profile in an unoxidized part of said semiconductor substrate unaltered, and said oxidation is performed until it stops by itself, and wherein said etching back comprises repeating said oxidation and subsequent etching off until a layer of predetermined thickness has been removed from said surface.

Advantageous embodiments are described in the dependent claims.

In accordance with the present invention, a method of providing a predetermined doping concentration at a surface of a semiconductor substrate is provided, which comprises applying a dopant material to the surface of the semiconductor substrate and performing a diffusion step for providing a predetermined doping profile from the surface into the body or bulk of the semiconductor substrate. Then, an etching back of the surface is done by performing an oxidization of the surface for generating an oxide thereon, and either simultaneously or subsequently etching off the oxide. The invention is characterized in that the oxidization is a chemical oxidization that is performed by employing a substrate or compound that oxidizes the semiconductor substrate at a low temperature between 20°C and 90°C and that leaves the doping profile in an unoxidized part of the semiconductor substrate unaltered.

As a consequence, it is not necessary to perform a complicated control procedure for performing a simultaneous oxidization and diffusion as this was the case in the known etch back procedure. The first step of generating a doping profile can be conducted independently of the subsequent oxidization, and the oxidization can be done independently of the diffusion that leads to the doping profile. All this can be achieved by using a chemical oxidization instead of a thermal oxidization. A thermal oxidation is an oxidation that occurs at elevated temperatures in an O₂ containing atmosphere.

The chemical oxidization step can be performed in any suitable or desirable way, by employing a substance or compound that is capable of oxidizing the semiconductor substrate. Examples are O₃, DIO₃ (deionised water mixed with O₃), H₂O₂, HNO₃, H₂SO₄ and NH₄OH e.g. directly or in aqueous solution. Also mixtures with further substances may be applied, such as a mixture of O₃, deionised water and HF.

Due to the use of chemical oxidization, the oxidization can be performed at low temperatures, such as between 20°C and 90°C, such that no further diffusion of the dopant into the bulk material takes place. In other words, the diffusion profile remains unaltered. The chemical oxidization is self-stopping, such that no specific controls are required, and the completing of the process until self-stopping typically only takes between 10 to 100 seconds, i.e. is considerably faster than the thermal oxidization used in the known etch back techniques, in which the oxidization step took between 30 minutes and one hour. The thickness of the oxide layer generated by the self-stopping chemical oxidization will typically be in the range of 1 to 5nm, such that a very precise etching back can be performed, without the necessity of any special control operations. If the etching back in the range of 1-5nm is not sufficient for removing the surface to a point where the concentration has a desired value, then the chemical oxidization and subsequent etching off can be repeated a desired plurality of times, which forms part of the invention.

Further aspects and advantages of the present invention will become more readily understandable from the following detailed description of embodiments, which, however, should not be understood as limiting.

### Brief Description of Figures

Reference will be made to the figure, where
Fig. 1 shows two doping profiles, one obtained by applying POCl₃ and another obtained by applying H₃PO₄, where the two doping profiles will be used to explain an effect of an embodiment of the present invention; and
Fig. 2 shows a magnified section of the graph of figure 1.

### Detailed Description

In the following, an application of the concept of the present invention to the field of manufacturing photovoltaic elements will be described. It is noted that this is a preferred application of the present invention, but that the present invention is by no means restricted thereto. Much rather, the general concept of first producing a predetermined doping profile from a surface into the bulk of semiconductor substrate and subsequently performing a chemical oxidization that leaves the doping profile unaltered in order to arrive at a suitable surface doping concentration can be applied within the entire field of semiconductor processing and manufacturing.

As it is known, photovoltaic elements generally comprise a pn junction, i.e. an emitter of one conduction type adjacent a base of opposite conduction type. Typically, the emitter is arranged at the light receiving side, but it can also be arranged at the opposite side. The basic structure of photovoltaic elements is well known in the art, such that a further description is not necessary.

According to a preferred embodiment of the invention, the concept of first doping and then performing a chemical oxidization is applied to the adjustment of the surface dopant concentration of the emitter of a photovoltaic element, such that on the one hand the surface dopant concentration is high enough in order to allow metallization via screen-printing with a metal containing paste, and on the other hand is not so high as to impair the electrical characteristics of the photovoltaic element, e.g. due to an lowered open circuit voltage or short circuit current caused by absorption of photons and recombination of charge carriers at the surface. Namely, if the surface doping concentration is higher than necessary for metallization, this leads to a reduction in the efficiency of the element on account of the reduction in open circuit voltage and short current circuit.

In a first step, a suitable dopant material is applied to the surface of a semiconductor substrate, e.g. to a silicon wafer, and diffusion is conducted for providing a predetermined doping profile from the surface into the body of the semiconductor substrate. The choice of dopant material will depend on the desired electrical properties. For example, in order to provide n-type conductivity, phosphorus or any other known n-type producing dopant can be used in silicon. It is noted that the present application is not restricted to any specific type of dopant or conductivity type, and can e.g. also be applied in the case of p-doping e.g. using aluminium in silicon. If the semiconductor substrate has a base doping type opposite to the type of dopant, a pn-junction is obtained.

When conducting an n-type doping by using phosphorus as a dopant, the material for providing phosphorus can be chosen in any suitable or desirable way. For example, the dopant material containing phosphorus can be a gas-phase material (such as POCl₃) or a liquid-phase material (e.g. solution of H₃PO₄).

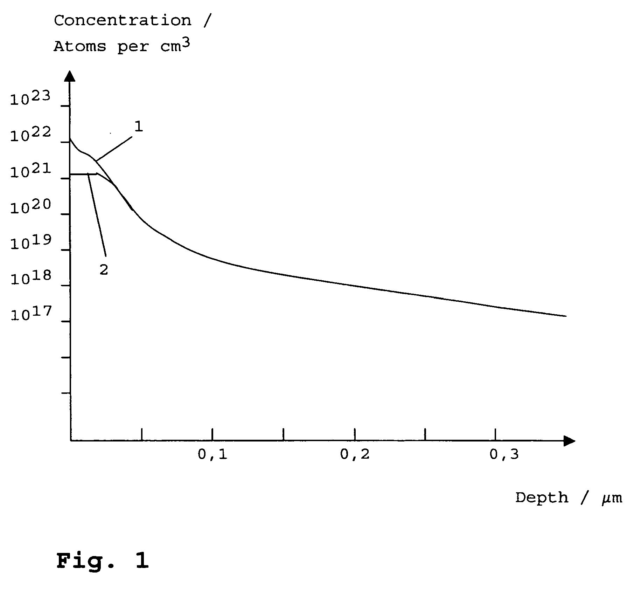

Figure 1 shows examples of doping profiles obtained by doping silicon with phosphorus, where profile 1 was obtained by application of H₃PO₄ and subsequent diffusion by heating, and profile 2 was obtained by applying POCl₃ to the heated wafers. It can be seen that the difference in the two profiles is essentially only present at and in the vicinity of the surface of the semiconductor substrate, up to a depth of about 0.05 µm in the example of Figure 1.

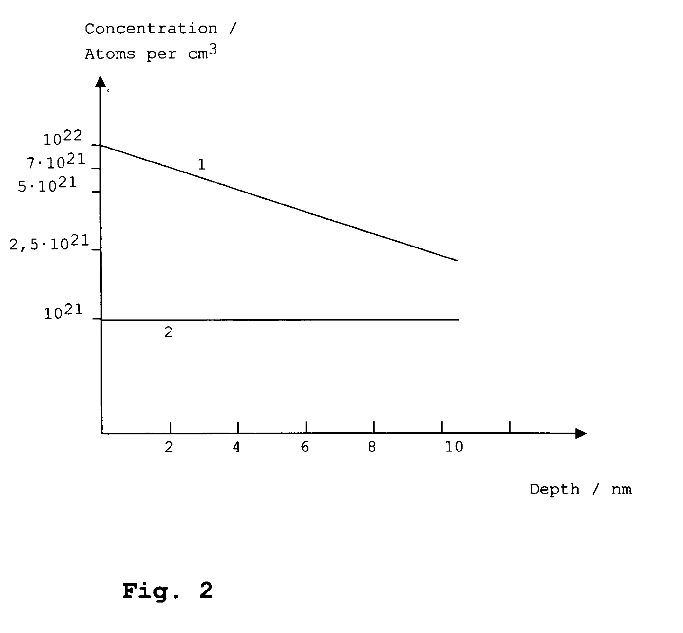

Figure 2 shows an enlarged view of profiles 1 and 2 in a range of depth of 10nm. As can be seen, an etching back of the surface by about 2nm in the case of doping profile 1 reduces the surface doping concentration from about 10²² atoms per cm³ to about 7×10²¹ atoms per cm³. An etching back of 5nm reduces the surface doping concentration to about 5×10²¹ atoms per cm³, and an etching back by 10nm reduces the surface doping concentration to about 2,5×10²¹ atoms per cm³.

The etching back is done by oxidizing the surface and then etching off the resulting oxide, where the oxidization is a chemical oxidization that leaves the doping profile in the unoxidized part of the substrate unaltered. In other words, looking at the example of profile 1 in Figure 2, the chemical oxidization can be such that the outer 3nm of the substrate are chemically oxidized, which would leave the profile 1 in the substrate beyond the 3 nm mark unaltered, such that after removal of the oxide of thickness 3nm the result would be a shift of profile 1 to the left by 3nm in the graph of Figures 1 and 2. This is in complete contrast to the known etch back techniques in which a thermal oxidization is performed such that the oxidization step itself would strongly alter the doping profile, which makes the control of the overall process very complicated.

In the method of the present invention, the chemical oxidization can be done at low temperatures, e.g. between room temperature (20°C) and 90°C, such that the temperature does not modify the existing doping profile due to a further diffusion effect. As already mentioned, the chemical oxidization step is self-stopping, as the oxide being generated prevents a further oxide growth if there is no oxide removing agent present. This makes the process very simple to control, as in fact no control is necessary. Depending on the type of substrate and the oxidizing agent, typically achievable oxide thicknesses can be in the range of 1 to 5nm. As an example, if one assumes a generation of an oxide of thickness 3nm, then a single step of oxidizing and subsequent etching off of the oxide can achieve a reduction in surface dopant concentration for doping profile 1 of Figure 2 from 10²² to under 7×10²¹ atoms per cm³. According to the invention , if it is desired to achieve a further reduction in surface doping concentration, then the oxidization and subsequent etching off can be repeated a desired number of times, until a layer of a predetermined thickness has been removed from the surface. In keeping with the example of doping profile 1 and an assumed oxide thickness of 3nm for the self-stopping chemically grown oxide, then two repetitions (i.e. three cycles of oxidizing and etching off in all) leads to a removal of about 9nm from the substrate surface, and therefore to a reduction in surface doping concentration from 10²² to about 3×10²¹ atoms per cm³.

In connection with doping profile 2, it can be seen that a change in the surface doping concentration would require more repetitions for achieving an effect, e.g. 10 to 15 cycles in order to remove between 30 and 45nm from the surface.

It is noted that the profiles shown in figures 1 and 2 are only examples, and the concept of the invention can be applied to any doping profile, e.g. also to a doping profile that shows an increase in doping concentration with increasing depth. In this case the etching back of the surface leads to increase in surface doping concentration.

The oxidization step can be done by using any suitable substance that is capable of chemically oxidizing the semiconductor substrate, typically made of silicon. This can be achieved by applying one or more of O₃, DIO₃, H₂O₂, HNO₃, H₂SO₄ and NH₄OH. The oxidization can be done by applying the mentioned substances individually or in combination.

The removal of the oxide can be done in any suitable or desirable way, preferably by using a HF solution. However, in a further example the etching off of the oxide can also e.g. be done by plasma etching.

It is also possible, but not forming part of the invention, to mix the oxidizing agent with further substances. As an alternative to the example of a self-stopping process and subsequent oxide removal, it is possible to perform the oxidization and oxide removal process simultaneously by using a mixture of an oxidizing agent (such as O₃) and an oxide removing agent (such as HF). An example of such a mixture is the previously mentioned mixture of O₃, deionised water and HF. The thickness of the removed layer then depends on the concentrations of the oxidizing agent, the concentration of the oxide removing agent and the amount of time of applying the mixture.

Now further detailed embodiments will be described specifically in connection with the manufacturing of photovoltaic elements. It is known to perform doping with phosphorus in silicon, in order to produce n-type emitters for solar cells. The doping with phosphorus can be accomplished using a gas phase diffusion with POCl₃, which can lead to the profile 2 shown in Figures 1 and 2, and an alternative method consists in using phosphoric acid (H₃PO₄) and a subsequent heating step in a belt furnace. The advantage of using phosphoric acid, which can e.g. be applied in liquid form by immersing the wafers or can be transported as an aerosol with the help of a nebuliser, is the homogeneity of the process, simplified process control in comparison with gas phase processing using POCl₃, and simplified equipment. However, phosphorus doping using phosphoric acid has the disadvantage that the resulting surface concentration is higher than when performing gas phase diffusion with POCl₃. The higher surface doping concentration leads to a reduced open circuit voltage and reduces short circuit current on account of photon absorption. This in turn leads to a reduced efficiency of the photovoltaic element of approximately 0.5% absolute in comparison with photovoltaic elements in which the doping of the emitter was performed using POCl₃ diffusion.

An embodiment of the present invention offers a solution to the above-mentioned problem. Namely, by etching back the surface of the semiconductor after the generation of the doping profile, the high surface doping concentration generated by the process with phosphoric acid can be reduced, thereby obtaining an improved efficiency, while at the same time avoiding the complexities of the gas phase POCl₃ diffusion process.

Experiments were conducted in order to compare the results of a process that performs doping using phosphoric acid and subsequent etching back using chemical oxidization with a standard process that used diffusion from a POCl₃ gas phase for doping and which did not have any subsequent etch back step. The doping step used a solution of H₃PO₄ of 30% by weight of total solution, where the phosphoric acid solution was nebulised and therefore applied as an aerosol to the wafers. Subsequently, the wafers were transported through a belt furnace for a diffusion step at 900°C for 10 minutes. It is noted that the given values are only examples and concentrations of 10 to 30% of phosphoric acid by weight of total solution are suitable, and the diffusion temperature can be in a range of 850° to 950°C. The diffusion time can be anywhere between 5 and 20 minutes. It is furthermore noted that the phosphoric acid can also be applied in immersion baths, in which case lower concentrations are possible, i.e. 3% to 5% by weight of total solution.

Subsequently, a HF solution of 2,5% by weight of total solution was applied for 30 seconds in order to remove phosphor glass. It is noted that solutions of 0,5 to 10% are suitable, and the HF solution can be applied either in immersion baths or by a nebuliser.

Subsequently, the wafers were treated in a HNO₃ solution having a concentration by weight of total solution of 69% at 90°C for one minute. This self-stopping chemical oxidization provided an oxide thickness of between 3,5 and 4,5 nm per oxidization step. Subsequently, the oxide was removed using a HF solution of 2,5% by weight of total solution for 30s at room temperature. Experiments showed that photovoltaic elements in which the emitter doping was done using phosphoric acid, but in which no subsequent etching back using chemical oxidization took place, achieved efficiencies of at best 15,8%.

Using gas phase POCl₃ for phosphorus doping provided photovoltaic elements with an efficiency of up to 16,3%.

However, when applying the etch back using chemical oxidization after phosphoric acid emitter doping in accordance with the invention, a single etch back cycle using HNO₃ as described above and subsequent HF removal led to photovoltaic elements with an efficiency of up to 16,4%, and using two cycles an efficiency of up to 16,7% was obtainable. As a consequence, when performing the emitter doping with phosphoric acid, an efficiency gain in the manufactured photovoltaic elements of almost 1% absolute was observed. Compared with the maximum of 15,8% for photovoltaic elements with phosphoric acid emitter doping and without etch back, this is a relative improvement of 6%.

It is noted that the above example for the oxidization step using HNO₃ were only examples, and other parameter values are possible. For example, the concentration can be chosen in a range between 30% and 75% by weight of total solution, and the temperature can be chosen in a range of 20°C to 90°C. Equally, the processing time can be chosen between 20 s and 20 minutes.

Up to now the invention was described in terms of method embodiments. Additionally, an example of a system for carrying out the above described methods is given. An example may therefore e.g. consist in a system for providing a predetermined doping concentration at a surface of a semiconductor substrate, comprising a section for applying a dopant material to said surface and performing a diffusion step for providing a predetermined doping profile from said surface into a body of said semiconductor substrate, and a section for etching back said surface by performing an oxidization of said surface for generating an oxide thereon, and etching off said oxide, wherein said oxidization is a chemical oxidization that leaves said doping profile in an unoxidized part of said semiconductor substrate unaltered.

The section for applying dopant material and performing diffusion may e.g. comprise a chamber for nebulizing an aqueous solution of H₃PO₄, with a transport device for carrying the Si wafers through the H₃PO₄ aerosol in the chamber, as well as a subsequent belt furnace for heating the wafers to a temperature between 850°C and 950°C during the transport through the furnace. As an alternative to the chamber with nebulized H₃PO₄, an immersion bath containing a solution of H₃PO₄ and provided with a transport mechanism for wafers is equally possible. A further alternative for applying the phosphoric acid is to perform a spin-on or spray-on. The section for etching back the surface may comprise a chamber for nebulizing an aqueous solution of HNO₃, said chamber having a transport mechanism for wafers, followed by an immersion bath containing an aqueous HF solution for removing the oxide, again with an appropriate transport mechanism for wafers. Alternatively, the HNO₃ may also be applied in an immersion bath, and the oxide removal may be done with the help of a nebulized HF solution.

As can be seen, the structure of the production system is simple, and on account of the independence of the step for forming the doping profile and the step for adjusting the surface doping concentration, the control of the production system is equally simple.

## Claims

1. A method of providing a predetermined doping concentration at a surface of a semiconductor substrate, comprising
- applying a dopant material to said surface and performing a diffusion step for providing a predetermined doping profile from said surface into a body of said semiconductor substrate, and
- etching back said surface by performing an oxidization of said surface for generating an oxide thereon, and etching off said oxide,
- said oxidization being a chemical oxidiziation that is performed by employing a substance or compound that oxidizes the semiconductor substrate at low temperatures between 20°C and 90°C and that leaves said doping profile in an unoxidized part of said semiconductor substrate unaltered, **characterized in that** said oxidation is performed until it stops by itself, and said etching back comprises repeating said oxidization and subsequent etching off until a layer of predetermined thickness has been removed from said surface.

2. The method of claim 1, wherein said chemical oxidization comprises the application of one or more of O₃, DIO₃, H₂O₂, HNO₃, H₂SO₄ and NH₄OH.

3. The method of claim 2, wherein said chemical oxidization comprises the application of HNO₃ in a concentration of 30 % to 75 % by weight of total solution.

4. The method of claim 3, wherein said HNO₃ is applied for 10 to 100 seconds at 20° to 90° C.

5. The method of one of the preceding claims, wherein said applying of said dopant material comprises applying H₃PO₄ to said surface.

6. The method of claim 5, wherein said H₃PO₄ is applied in a concentration between 3 % and 30 % by weight of total solution.

7. A method for producing solar cells, comprising an emitter generating step that comprises the method of one of claims 1 to 6 for adjusting the dopant concentration at the surface of the emitter.

8. The method of claim 7, comprising a metallization of said emitter by screen-printing with a paste containing metal.

## Patentansprüche

1. Verfahren zur Bereitstellung einer vorbestimmten Dotierungskonzentration auf einer Oberfläche eines Halbleitersubstrats, umfassend die folgenden Schritte:
- Auftragen einer Dotierungssubstanz auf die Oberfläche und Durchführung eines Diffusionsschrittes zur Bereitstellung eines vorbestimmten Dotierungsprofils von der Oberfläche in einen Körper des Halbleitersubstrats, und
- Rückätzung der Oberfläche mittels Durchführung einer Oxidierung der Oberfläche zur Erzeugung eines Oxids auf der Oberfläche sowie Abätzung des Oxids,
- wobei die Oxidierung eine chemische Oxidierung darstellt, die durchgeführt wird mittels einer Substanz oder einer Verbindung, die das Halbleitersubstrates bei niedrigen Temperaturen zwischen 20° C und 90° C oxidiert und die das Dotierungsprofil in einem nicht oxidierten Teil des Halbleitersubstrats unverändert lässt, **dadurch gekennzeichnet, dass** die Oxidierung so lange durchgeführt wird, bis sie von selbst aufhört, und dass die Rückätzung eine Wiederholung der Oxidierung und anschließenden Abätzung umfasst, bis eine Schicht einer vorbestimmten Dicke von der Oberfläche entfernt worden ist.

2. Verfahren nach Anspruch 1, **dadurch gekennzeichnet, dass** die chemische Oxidierung das Auftragen von einer oder mehrerer der Substanzen O₃, DIO₃, H₂O₂, HNO₃, H₂SO₄ und NH₄OH umfasst.

3. Verfahren nach Anspruch 2, **dadurch gekennzeichnet, dass** die chemische Oxidierung das Auftragen von HNO₃ in einer Konzentration von 30% bis 75%, bezogen auf das Gesamtgewicht der Lösung, umfasst.

4. Verfahren nach Anspruch 3, **dadurch gekennzeichnet, dass** das HNO₃ für 10 bis 100 Sekunden bei 20° bis 90° C aufgetragen wird.

5. Verfahren nach einem der vorherigen Ansprüche, **dadurch gekennzeichnet, dass** das Auftragen der Dotierungssubstanz ein Auftragen von H₃PO₄ auf die Oberfläche umfasst.

6. Verfahren nach Anspruch 5, **dadurch gekennzeichnet, dass** das H₃PO₄ in einer Konzentration von 3% bis 30%, bezogen auf das Gesamtgewicht der Lösung, aufgetragen wird.

7. Verfahren zur Herstellung von Solarzellen, **gekennzeichnet durch** einen Emitter-Herstellungsschritt, der das Verfahren nach einem der Ansprüche 1 bis 6 zur Anpassung der Dotierungssubstanz-Konzentration auf der Oberfläche des Emitters umfasst.

8. Verfahren nach Anspruch 7, **gekennzeichnet durch** eine Metallisierung des Emitters mittels Siebdruck mit einer metallhaltigen Paste.

## Revendications

1. Procédé pour fournir une concentration de dopage prédéterminée à la surface d'un substrat de semi-conducteur, comprenant les étapes consistant à :
- appliquer un matériau dopant sur ladite surface et réaliser une étape de diffusion pour fournir un profil de dopage prédéterminé à partir de ladite surface dans un élément dudit substrat de semi-conducteur, et
- graver en retrait ladite surface en réalisant une oxydation de ladite surface pour générer un oxyde sur celle-ci, puis à éliminer par gravure ledit oxyde,
- ladite oxydation étant une oxydation chimique qui est réalisée en employant une substance ou un composé qui oxyde le substrat de semi-conducteur à de basses températures comprises entre 20 °C et 90 °C, et qui laisse ledit profil de dopage dans une partie non oxydée dudit substrat de semi-conducteur intact, **caractérisée en ce que** ladite oxydation est réalisée jusqu'à ce qu'elle s'arrête par elle-même, et
- ladite gravure en retrait consiste à répéter ladite oxydation et l'élimination consécutive par gravure jusqu'à ce qu'une couche d'une épaisseur prédéterminée ait été éliminée de ladite surface.

2. Procédé selon la revendication 1, dans lequel ladite oxydation chimique comprend l'application d'un ou plusieurs parmi O₃, DIO₃, H₂O₂, HNO₃, H₂SO₄ et NH₄OH.

3. Procédé selon la revendication 2, dans lequel ladite oxydation chimique comprend l'application de HNO₃ en une concentration de 30 % à 75 % en poids de la solution totale.

4. Procédé selon la revendication 3, dans lequel ledit HNO₃ est appliqué pendant 10 à 100 sec de 20°C à 90 °C.

5. Procédé selon l'une des revendications précédentes, dans lequel ladite application dudit matériau dopant consiste à appliquer du H₃PO₄ sur ladite surface.

6. Procédé selon la revendication 5, dans lequel ledit H₃PO₄ est appliqué en une concentration comprise entre 3 % et 30 % en poids de la solution totale.

7. Procédé de production de cellules photovoltaïques, comprenant un émetteur générant une étape qui comprend le procédé selon l'une des revendications 1 à 6 pour ajuster la concentration de dopant à la surface de l'émetteur.

8. Procédé selon la revendication 7, comprenant une métallisation dudit émetteur par sérigraphie avec un métal contenant une pâte.
